# EUROPEAN PATENT APPLICATION

(11) **EP 3 125 132 A1**
(43) Date of publication of application: **01.02.2017**
(21) Application number: 15178444.4
(22) Date of filing: 27.07.2015
(51) Int. Cl.: G06F 17/28, H03M 7/00

(54) **SYSTEM AND METHOD FOR REPRESENTING SEQUENCES OF BITS**

(71) Applicant: Advanced Digital Broadcast S.A., 1292 Geneva (CH)
(72) Inventor: Dabrowski, Bartosz, 65-119 Zielona Gora (PL)
(74) Representative: Blonski, Pawel

(57) **Abstract**

A computer-implemented method for representing sequences of bits, the method comprising the steps of: obtaining access to at least one dictionary, wherein each dictionary comprises entries of one type of part of speech each indexed with a unique key value (501); reading an input sequence of an input sequence of bits, the sequence being of a defined length (502); and splitting the input sequence into at least one subsequence, the at least one subsequence covering the complete input sequence, wherein each subsequence is associated with a part-of-speech dictionary and is represented by the associated dictionary's entry having a key value of the subsequence (503).

## Description

The present invention relates to a system and method for representing sequences of bits. In particular, the present invention relates to systems or environments that require identification or verification or validation or the like of pieces of data that are naturally described or identified by complex sets of letters or digits or symbols or the like. It is typically an inherent property of such data items that they are not easily readable by humans. Hence, if such data item needs validation by a human, this validation is typically faulty. Therefore, the present invention aims at improving this process and hence decrease likelihood of human errors resulting from complexity of data to be verified.

Existing solutions comprise, typically verification of long sequences of data items like symbols or bytes or the like, displaying, for a human operator, verification data hashes of data sequences. These hashes are CRC (Cyclic Redundancy Check) hash or SHA (Secure Hash Algorithm) or MD5 (Message Digest algorithm 5) or the like.

Each of the aforementioned, is a set of bytes represented usually as a number in a hexadecimal notation. This number when read by a human being is a complex set of symbols without any sense or logical connections between symbols. Hence, the verification of such is error prone. For instance, it is easy for a human to mismatch the following two values differing in one symbol only: 0DF4871A and 0DF4B71A. The symbols are different but can be easily mistaken and since they represent a different piece of data each, such error is often unacceptable. Another example is human verification of an SHA-1 hash number, which in hexadecimal notation contains 40 symbols. It is typical for environments that require speed to only compare 4 or 6 last or 4 or 6 first symbols of the number in order to state the correctness of the number or determine two numbers are equal.

It is common in computer systems to represent binary sequences with hexadecimal numeral system symbols. In other words, the sequences of bits may be shortened by utilizing number notation of a higher base e.g. instead of hexadecimal notation (base 16). This effectively shortens the displayed sequence making it easier to identify. However, it still remains a set of not logically related symbols without a sense to a human. Further, increasing the level of the numeral system to a base 24 or base 32 or higher notation results in too many combinations for humans to easily detect and distinguish in sequences comprising symbols. This is why mainly bases 2, 8, 10, 12 and 16 are in use. In this context a symbol represents a sequence of bits, for example in a hexadecimal notation an F symbol represents a sequence of four bits 1111.

Thus, there exists an unaddressed need for an improved method for representing sequences of bits that would be easily readable by humans (especially for the purpose of comparisons) as well as preferably having a base higher than 16.

The aim of the development of the present invention is an improved method for representing sequences of bits.

### SUMMARY AND OBJECTS OF THE PRESENT INVENTION

The first object of the present invention is a computer-implemented method for representing sequences of bits, the method comprising the steps of: obtaining access to at least one dictionary, wherein each dictionary comprises entries of one type of part of speech each indexed with a unique key value; reading an input sequence of bits, the sequence being of a defined length; and splitting the input sequence into at least one subsequence, the at least one subsequence covering the complete input sequence, wherein each subsequence is associated with a part-of-speech dictionary and is represented by the associated dictionary's entry having a key value of the subsequence.

Preferably, each subsequence is associated with a different part-of-speech dictionary and is represented by the associated dictionary's entry having a key value of the subsequence.

Preferably, the subsequences overlap.

Preferably, a sequence of dictionaries applied to a respective sequence of subsequences is predefined using rules.

Preferably, the step of splitting the input sequence into at least one subsequence, comprises the following steps: obtaining access to a first dictionary of all dictionaries obtained at step; determining, whether the input sequence definition has no more distinct possible sequences than the count of first parts of speech in the first parts-of-speech dictionary; in case it does each sequence according to the input sequence definition is represented by a first part of speech indicated by the unique key having value of the input sequence.

Preferably, if the determination step returns false, the method proceeds to: splitting the input sequence into a pair of subsequences, the first of the pair having distinct items count no higher than the count of first parts of speech in the first parts-of-speech dictionary; representing the first sequence of the pair by a first part of speech indicated by the unique key having value of the first subsequence of the pair; in case when more dictionaries are available, obtaining access to a second part-of-speech dictionary; determining whether the second subsequence of the pair has no more distinct possible sequences than the count of second parts of speech in the second parts-of-speech dictionary; In case it does, representing the second sequence of the pair by a second part of speech indicated by the unique key having value of the second subsequence of the pair.

Preferably, if the determination step returns false, the method proceeds to: removing the first parts of speech dictionary from the set of available dictionaries and setting the second subsequence of the pair as the input sequence; returning to the splitting step.

Preferably, if the determination step returns false, the method proceeds to: removing the first parts of speech dictionary from a new set of available dictionaries and setting the second subsequence of the pair as the input sequence; returning to the splitting step.

Preferably, the second part-of-speech dictionary is selected so that the resulting clause is a grammatically correct clause.

Preferably, the method further comprises the steps of: determining a definition of the input sequence; splitting, the definition of the input sequences into at least one subsequence, the at least one subsequence covering the complete input sequence definition, wherein each subsequence is associated with a different part-of-speech dictionary; obtaining a definition of the split as a result of the splitting step; splitting at least one input sequence according to the definition of the split.

Another object of the present invention is a computer program comprising program code means for performing all the steps of the computer-implemented method according to the present invention when said program is run on a client computer.

Another object of the present invention is a computer readable medium storing computer-executable instructions performing all the steps of the computer-implemented method according to the present invention when executed on a computer.

A further object of the present invention is a system for representing sequences of bits, the system comprising: a data bus communicatively coupled to other components of the system; a memory; a controller; the system further comprising: an input interface configured to obtain input data and to store an input sequence in an input sequence buffer; an output data buffer configured to store output data passed to an output interface; a dictionaries database comprising at least one part-of-speech dictionary; wherein the controller configured to execute all the method steps according to the present invention.

Preferably, the system further comprises: a dictionaries database further including rules applicable to selection of particular dictionaries during a process of analyzing and processing of input sequences.

### BRIEF DESCRIPTION OF THE DRAWINGS

These and other objects of the invention presented herein, are accomplished by providing a system and method for representing sequences of bits. Further details and features of the present invention, its nature and various advantages will become more apparent from the following detailed description of the preferred embodiments shown in a drawing, in which:
Fig. 1 presents a selection of a clause class and a hash algorithm;
Fig. 2A and fig. 2B present the method for dividing a hash into indicia with regard to the number of words in each part of speech affecting the number of possible clauses in the clause class;
Fig. 3 presents exemplary sets of words indexed as to best fit the presented exemplary embodiment;
Fig. 4 presents an example according to the exemplary embodiment of transforming a CRC-32 hash value into a natural language clause;
Fig. 5 presents a general concept of the method according to the present invention;
Fig. 6A and fig. 6B present an exemplary embodiment of the method according to the present invention comprising a recursive method of finding the linguistic representation of data;
Fig. 7 presents a system according to the present invention;
Fig.8 presents a sequence splitting example where two overlapping output subsequences exist; and
Fig. 9 presents a modification of the embodiment according to Fig. 5.

### NOTATION AND NOMENCLATURE

Some portions of the detailed description which follows are presented in terms of data processing procedures, steps or other symbolic representations of operations on data bits that can be performed on computer memory. Therefore, a computer executes such logical steps thus requiring physical manipulations of physical quantities.

Usually these quantities take the form of electrical or magnetic signals capable of being stored, transferred, combined, compared, and otherwise manipulated in a computer system. For reasons of common usage, these signals are referred to as bits, packets, messages, values, elements, symbols, characters, terms, numbers, or the like.

Additionally, all of these and similar terms are to be associated with the appropriate physical quantities and are merely convenient labels applied to these quantities. Terms such as "processing" or "creating" or "transferring" or "executing" or "determining" or "detecting" or "obtaining" or "selecting" or "calculating" or "generating" or the like, refer to the action and processes of a computer system that manipulates and transforms data represented as physical (electronic) quantities within the computer's registers and memories into other data similarly represented as physical quantities within the memories or registers or other such information storage.

A computer-readable (storage) medium, such as referred to herein, typically may be non-transitory and/or comprise a non-transitory device. In this context, a non-transitory storage medium may include a device that may be tangible, meaning that the device has a concrete physical form, although the device may change its physical state. Thus, for example, non-transitory refers to a device remaining tangible despite a change in state.

As utilized herein, the term "example" means serving as a non-limiting example, instance, or illustration. As utilized herein, the terms "for example" and "e.g." introduce a list of one or more non-limiting examples, instances, or illustrations.

### DESCRIPTION OF EMBODIMENTS

The present invention aims at providing an unambiguous and reversible method of representing any piece of data by a sequence of words in some natural language that will be easily readable by a human. This is based on the following assumptions: (a) words must be taken from at least on dictionary of parts of speech of a natural language; (b) words sequence is preferably short enough for a human to read and easily distinguish from another words sequence; (c) words in a word sequence are preferably such that they form an easily readable sentence or clause or epithet or the like; usually meaning that the parts of speech of any two (usually adjacent) words should preferably match the rules of the particular natural language. In other words a sequence of dictionaries applied to a respective sequence of subsequences is predefined using rules.

An exemplary embodiment of these rules is a sequence of two words, of which the former is an adjective and the latter is a noun i.e. the parts of speech are different. Such two words will always be readable, regardless of potential lack of sense in the meaning of such sequence.

The present invention discloses a method for processing and representing a sequence of symbols (sequence of bits, bytes, words or the like) as a human readable and easily readable sequence of words. For the purpose of the present invention the following terms are defined and used hereinafter:
(a) clause - a sequence of words;
(b) clause class - a set of all clauses that are formed using a sequence of words of which on any given position in that sequence a word is always one part of speech of a natural language e.g. epithet is a clause class comprising two words: an adjective on the first position and a noun on the second position;
(c) grammatically correct clause - a clause that is constructed according to rules of selected grammar e.g. a clause "yellow cat" or a clause "hermetical dog" is grammatically correct although makes no sense to an average human. On the other hand, the clause "yellow go" or "country at" is not grammatically correct due to respective grammar does not allow the collocation of adjective and verb or noun and preposition in the presented order.

The present invention comprises a method for unambiguous and reversible identification of large and complex data. The reversibility is however considered optional.

The method, in one embodiment, comprises a computation of a hash of the source data. It further comprises a method to split that hash into indicia and further comprises a method to assign words to particular indicia.

The method preferably comprises guidelines for selecting words from a dictionary and is preferably customized to fit a particular language. Further, there is disclosed a method to convert the indicia into a grammatically correct clause.

For example, The Second Edition of the Oxford English Dictionary contains full entries for 171,476 words in current use, and 47,156 obsolete words. To this may be added around 9,500 derivative words included as subentries, bringing the total to 180,976.

Over half of these words are nouns, about a quarter adjectives, and about a seventh verbs; the rest is made up of interjections, conjunctions, prepositions, suffixes, etc. These figures take no account of entries with senses for different parts of speech (such as noun and adjective).

Based on this, a dictionary of English nouns may have a 16-bit unique index key and thus cover a 16-bit input sequence with a single, unique noun. Such dictionaries may be ordered such that neighboring entries (key value differing by 1) will not be similar words (in terms of sequence of letters) but they will differ significantly, for example the first letter or two letters of neighboring words are different. The ordering of the entries in a dictionary may also depend on the content of the input sequences to be processed by the system, when such content is known (for example a CRC value).

The method, according to the present invention, comprises obtaining access to at least one dictionary, wherein each dictionary comprises entries of one type of part of speech each indexed with a unique key value (501), wherein the part of speech can be a noun or a verb or an adjective or the like.

A part of speech is preferably a natural language part of speech. Nevertheless, in some embodiments a part of speech may be defined for the purpose of the present method or can be modified from the generally known definition, which is not limiting to the present invention in any way.

The method further comprises reading an input sequence of an input sequence of bits, the sequence being of a defined length (502). The sequence may come as a data set of predefined length, e.g. four bytes, or come as an input stream of an unknown length. In the latter case, there may be used a buffer of a given data size and as soon as the buffer has been filled with data, its content, of a known length, is submitted for processing by the present method, while the buffer is filled again with a new data set read from the input stream of an unknown length.

The method further comprises a step of splitting the input sequence into at least one subsequence, the at least one subsequence covering the complete input sequence, wherein each subsequence is associated with a different part-of-speech dictionary and is represented by the associated dictionary's entry having a key value of the subsequence (503). In one of the embodiments of the present invention, each subsequence is associated with a part-of-speech dictionary, not necessarily different part-of-speech dictionary.

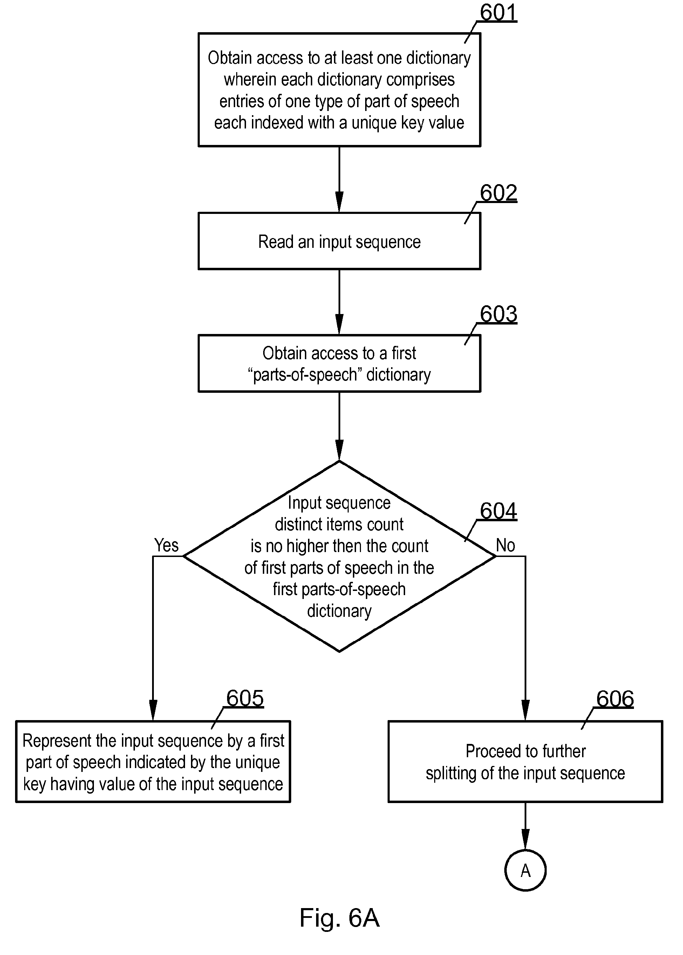

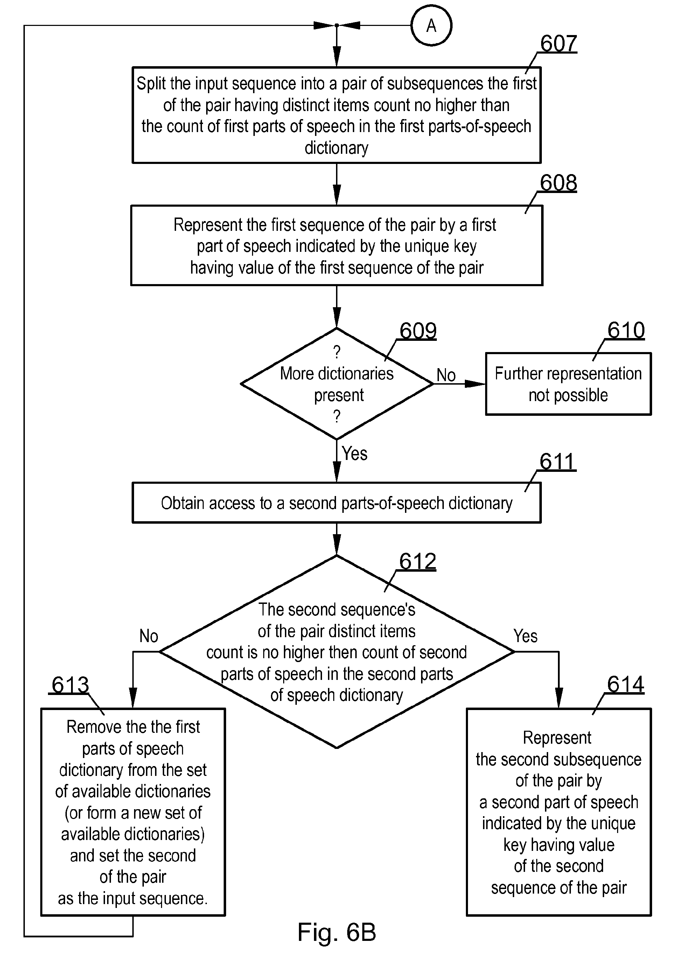

Depending on an approach chosen, the determination of how to split an inputs sequence into at least one subsequence, may be executed prior to receiving the input data (for example a data set has a fixed length and a fixed part of speech dictionary(s) will be used wherein a sequence of selection of different part of speech dictionaries is fixed) or after receiving the data. The latter method is however preferred, as it is more flexible. More details regarding this approach have been provided with reference to Fig. 6A and Fig. 6B.

Fig. 6A and fig. 6B present an exemplary embodiment of the method according to the present invention. The method begins at step (601) with obtaining access to at least one dictionary, wherein each dictionary comprises entries of one type of part of speech each indexed with a unique key value.

This key value is preferably an ordinal index. However, the use of other forms of the key is in no way limiting to the present invention. An exemplary embodiment of such dictionary may be a list of adjectives of the English language, of which each adjective has an index assigned constituting its position on the dictionary list.

Next at step (602) the input sequence of symbols is read. The sequence has a defined length, for example 32, 64 or 128 bits.

Next, at step (603) access is obtained to a first dictionary of all dictionaries obtained at step (601). Naturally, the dictionaries may be stored locally or remotely as required by a particular implementation of the present method.

At step (604) it is decided whether the input sequence definition has no more distinct possible sequences (for example a binary sequence of 16 bits has 65536 possible different sequences, in case of 12 bits there are 4096 different sequences possible) than the count of first parts of speech in the first parts-of-speech dictionary. If this is true, then at step (605) each sequence according to the input sequence definition can be represented by a first part of speech indicated by the unique key having value of the input sequence. Thus a single subsequence covers the whole range of values of the input sequence.

Otherwise, if the input sequence definition has more distinct possible sequences than the count of first parts of speech in the first parts-of-speech dictionary, the method proceeds at step (606) to further splitting of the input sequence into subsequences.

Moving to fig. 6B then at step (607) the input sequence definition is split into a pair of subsequences, the first of the pair having distinct items count no higher than the count of first parts of speech in the first parts-of-speech dictionary.

Next, at step (608), the method represents the first sequence of the pair by a first part of speech indicated by the unique key having value of the first subsequence of the pair. Thus, the second subsequence of the pair is left unrepresented at this step. Further steps of the present embodiment of the present method will aim at recursively representing said second subsequence of the pair.

Hence, at step (609) the method determines whether more dictionaries are available. If not, then at step (610) it is construed that further representation of the input sequence definition by the present embodiment of the present method is not possible and the method ends.

In case when more dictionaries are available at step (609), then at step (611) the method obtains access to a second part-of-speech dictionary. The second part-of-speech dictionary is preferably selected so that the resulting clause is a grammatically correct clause. For example, there may be set rules, which define that a given part-of-speech dictionary entry may only be followed, in the output data, by another, particular part-of-speech dictionary entry e.g. a first part-of-speech dictionary comprises nouns wherein a noun, in the output data, may only be followed by a verb or adjective present in respective part-of-speech dictionaries. Naturally, different definitions of such rules, of dictionaries' use, are possible depending on particular needs, the target person as well as a selected natural language.

It is also possible that the rules of the grammar may require a selection of two or more dictionaries at once in the presented steps (609) and (611) or to modify the sequence of the already selected dictionaries or removing of one or more of them or the like. In any case the present embodiment of the present invention may be adjusted to such situations and such situation is not to be construed as a limitation to the present invention.

Next at step (612) the method determines whether the second subsequence of the pair has no more distinct possible sequences than the count of second parts of speech in the second parts-of-speech dictionary. If this is true, then at step (614), the method represents the second sequence of the pair by a second part of speech indicated by the unique key having value of the second subsequence of the pair. Hence, the whole input sequence is represented by a sequence of representations constructed by the present method.

If at step (612), the second subsequence of the pair has more distinct possible sequences than the count of second parts of speech in the second parts-of-speech dictionary, the method removes at step (613) the first parts of speech dictionary from the set of available dictionaries (or form a new set of available dictionaries) and sets the second of the pair as the input sequence. It is possible that the parts of speech are repeated in the target clause and hence, the dictionaries may be used more the once. This is to be considered as a design choice for a given implementation of the present invention and is in no way limiting to the present invention.

Hence, the method next goes back to step (607) to recursively continue the search for the representation of the remainder of the input sequence definition.

It is clear from the aforementioned, that if used for data identification for interpretation by humans, the present invention is most useful when representing sequences that allow representation by clauses that do not exceed certain complexity or length. These of course may vary depending on various factors. It is however clear that large data e.g. several kB long cipher keys or the like are almost always too long for most practical purposes even if represented according to the present invention. Hence, the present invention is particularly useful when applied to hashes (values returned by a hash function, which is any function that can be used to map digital data of arbitrary size to digital data of fixed size) of large and complex data structures.

Hereinafter, follows an exemplary embodiment of the present invention comprising a method to select a clause class and a hash algorithm that are used by subsequently presented exemplary embodiments of the present invention to construct an unambiguous method to assign a specific clause to a specific hash.

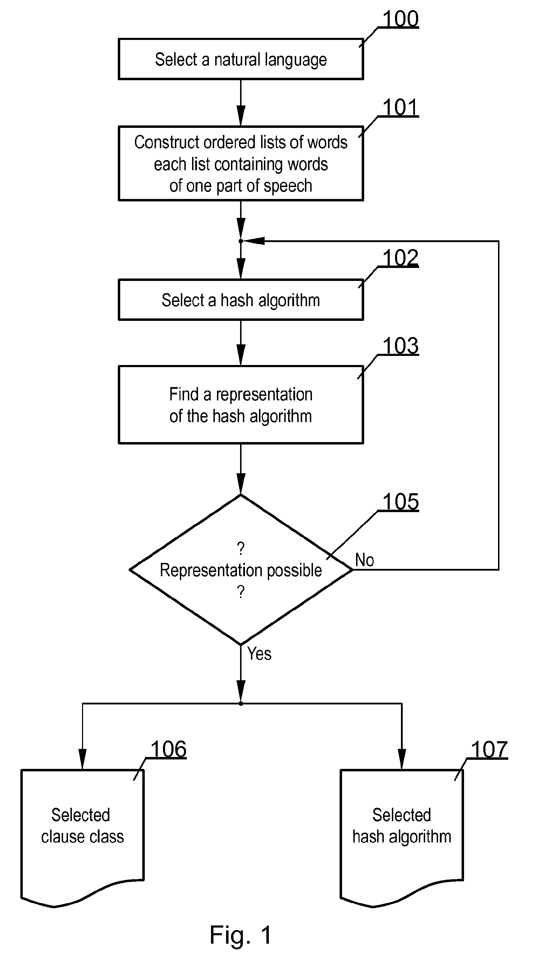

Fig. 1 presents a method of selecting a clause class and a hash algorithm. The method presented, validates whether a selected hash algorithm may be used with a selected clause class. It does not however, provide the method of searching for a match.

The method begins at step (100) with selecting a target natural language of which the words are going to be taken and against whose grammar the validity of a clause will be determined. At next step (101) the method constructs dictionaries needed to prepare a linguistic representation of the input data. The dictionaries are preferably lists of words, wherein each dictionary comprises words of just one part of speech e.g. adjectives or verbs or the like. The dictionaries are preferably ordered and indexed.

In one embodiment of the present invention, values determined in this step can be estimated first and computed at later stage after specific clause class is selected or even estimated at a later stage accepting a certain risk of needing to repeat the process or a similar modification.

The method then moves on to step (102) in order to select a hashing algorithm. Examples of possible hashes are CRC-16 or SHA-1 or MD5 or the like. Subsequently, the representation is found according to the present invention at step (103). The result of step (103), is the clause class for identification of the hash and a representation allowing to translate the hash into the clause.

At step (105) it is checked whether the method according to the present invention can represent the hash. If so, then the present method selects the hash algorithm (107) and the clause class (108).

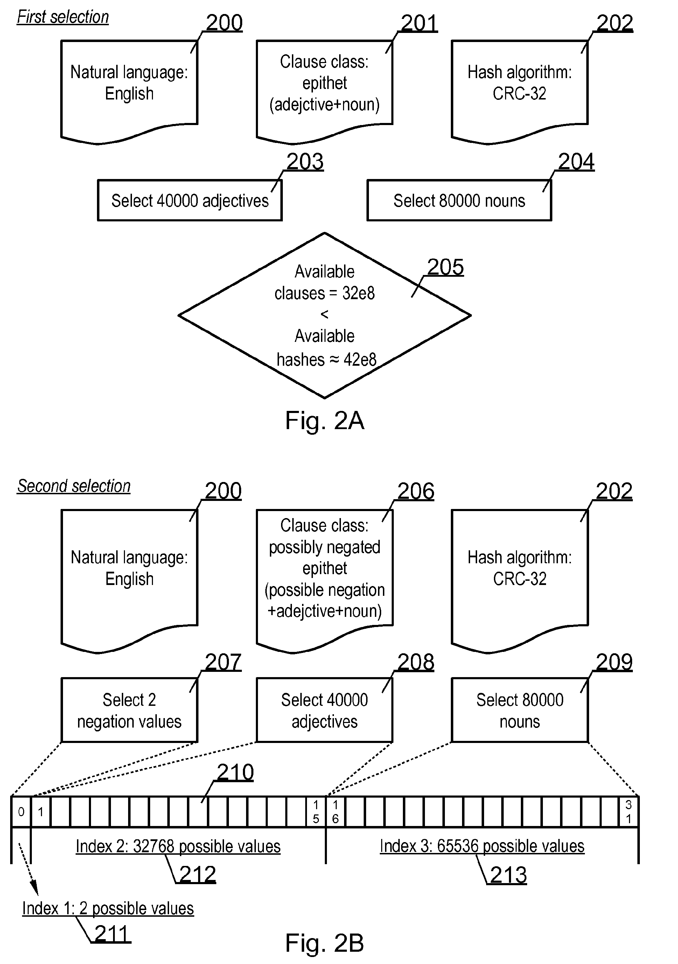

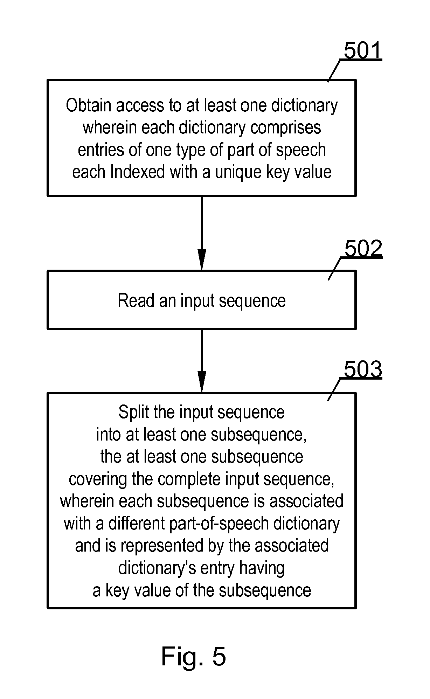

Another exemplary embodiment of the present invention is presented according to the presented method thus comprising a more specific example. The embodiment uses the method described by Fig. 1 and respectively Fig. 5 and Fig. 6A and Fig. 6B in order to select a language, clause class and a hash algorithm. There are selected (Fig. 2A):
- English language (200);
- Two dictionaries are available: an ordered list of adjectives and an ordered list of nouns; and
- CRC-32 (202) algorithm: cyclic redundancy check with a 32 bit length.

The method assumes only two dictionaries are available. They contain 80000 nouns (204) in the English language and 40000 adjectives (203) respectively. The method according to Fig. 6B will construe that the representation is not possible at step (610).

It is clear that in this case this can be estimated regardless of the method as there are only 32⁸ distinct clauses in the selected class. At the same time a CRC-32 algorithm provides no less than 42⁸ distinct values. This is more than the selected clause class can cover. However, this is merely a specific example and is in no way limiting to the present invention.

Therefore the present embodiment enhances the selection (Fig. 2B):
- English language is unchanged (200);
- Three dictionaries are available: an ordered list of adjectives and an ordered list of nouns and an ordered list of two items: "" (empty word) and "not" (indication of negation) being an exemplary embodiment of a part of speech defined for the purpose of the present method as already described above;
- CRC-32 (202) algorithm: cyclic redundancy check with 32 bit length is unchanged.

Such selection doubles the number of possible clauses in a newly selected clause class (206). Subsequently, the present embodiment of the present invention maps the three parts of speech (207) and (208) and (209) into a 32 bit representation of a CRC-32 hash number based on a number of words available for each part of speech. This mapping is according to the method according to the present invention. The following mapping is done:
- Index 1 (211) over bit 0: the first bit of value 0 means an empty negation, value of 1 means the "not" word;
- Index 2 (212) over bits 1 through 15: interpreted as a whole number it selects one of the 32768 adjectives selected for this index from all the adjectives (208);
- Index 3 (213) over bits 16 through 31: interpreted as an integer value, selects one of the 65536 nouns selected for this index from all the nouns (209).

The present mapping presents a grammatically correct clause according the nomenclature presented in the present invention. Hence, the present mapping, comprising the three aforementioned parts of speech, is called a possibly negated epithet hereinafter.

Therefore, any number, being a 32 bit CRC hash of any piece of data, can be mapped by the presented indicia of the present method, into a set of three ordered, natural language words, of which each is selected by its respective index (211) or (212) or (213).

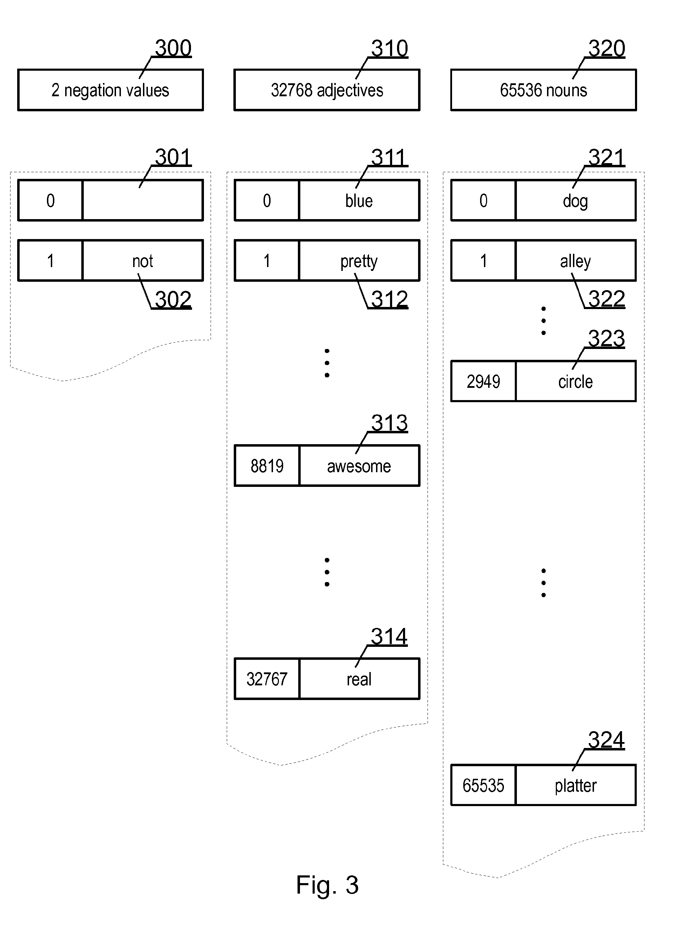

An example of such a mapping, according to the present invention, has been provided in Fig. 3. Fig. 3 further depicts that of the set of available 40000 adjectives (208), only 32768 (310) are needed to fill index 2 (212) and out of 80000 nouns (209) only 65536 (320) are needed to fill index 3 (213). The indicia (211) and (212) and (213) are created over ordered sets of words (300) and (310) and (320) respectively. It is in no way limiting to the present invention how the words are ordered in those sets. Typically the words will be randomly ordered or alphabetically ordered if selected by automated methods from the language's dictionary. It is clear that typically, when used with hash algorithms such as CRC or SHA or the like, the randomization of the order of the sets of words (300) and (310) and (320), of dictionaries, is not needed due to the inherent scattered nature of the hash algorithms' values.

Therefore, Fig. 3 presents three sets of words: negation (300) and adjectives (310) and nouns (320). Further, the set (300) contains two elements: an empty value (301) and "not" (302).

Furthermore, the set (310) contains 32768 values beginning at 0 with "blue" (311), then 1 with "pretty" (312) and ending with 32767 with "real".

Furthermore, the set (320) contains 65536 values beginning at 0 with "dog" (321), then 1 with "alley" (322) and ending with 65535 with "platter".

For the purpose of the present example of the present invention, two "mid-way" values are presented in Fig. 3: an adjective "awesome" (313) at index 8819 and a noun "circle" (323) at index 2949.

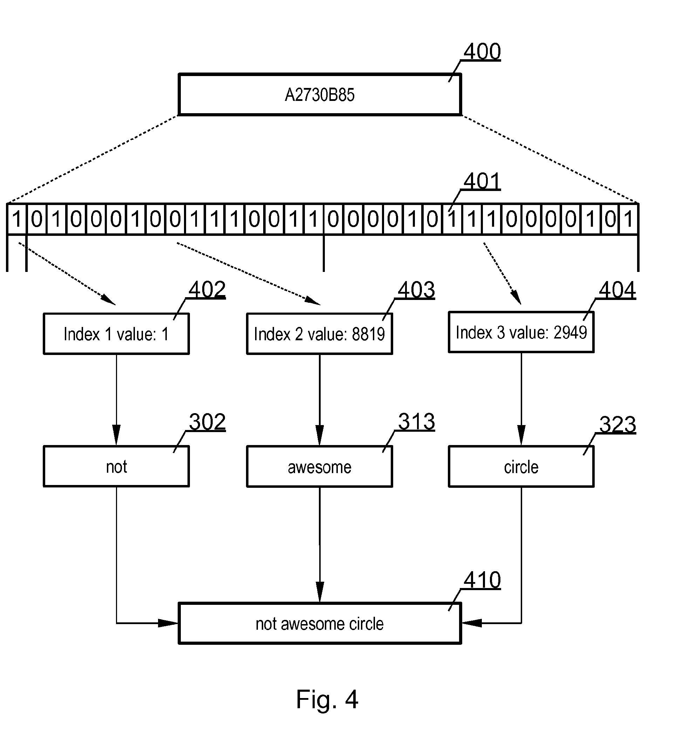

Moving on to Fig. 4, the present example presents an exemplary value of a CRC-32 hash (400) of A2730B85 (hexadecimal notation). The binary representation of this value (401) is split according to the selected indicia (211) and (212) and (213). The values of those indicia noted in decimal are respectively: 1 at item (402) and 8819 at item (403) and 2949 at item (404).

According to Fig. 3, these values are indicia of the following respective words in their respective ordered sets: "not" (302) and "awesome" (313) and "circle" (323).

Hence, the resulting possibly negated epithet class clause is "not awesome circle" (410).

It is clear that this clause is not logical to an average human or carries no real sense. It is however easily readable and it is difficult to make a mistake while reading it and trying to differentiate from another one.

It is also an advantage, that the present embodiment of the present invention is easily reversible and it allows to reverse the process to transform the possibly negated epithet clause (410) into its source CRC-32 hash value (400) using the same ordered sets (300) and (310) and (320).

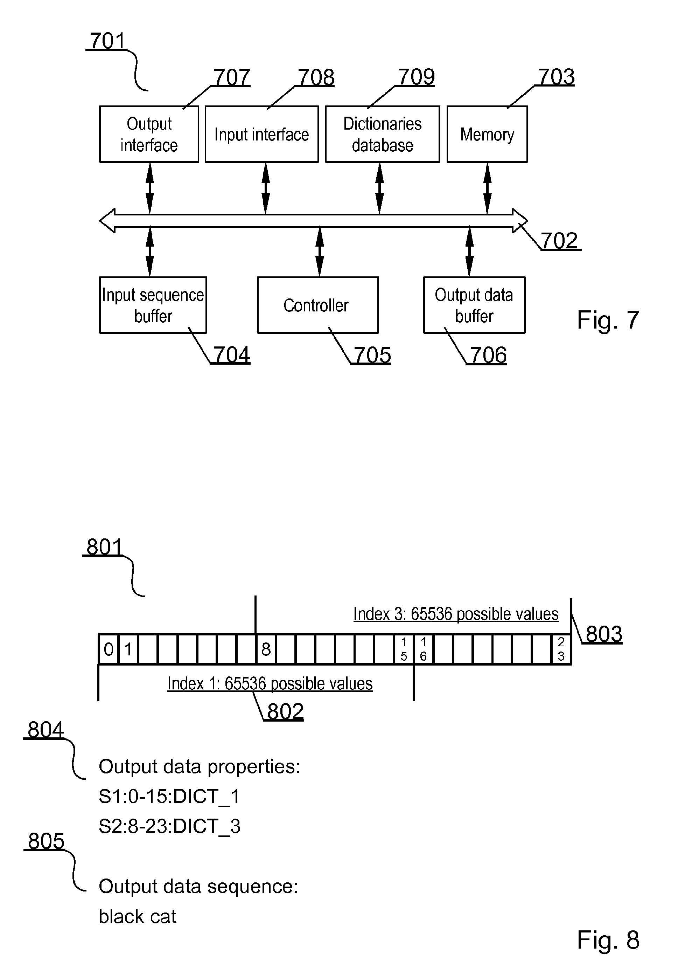

Fig. 7 presents a general overview of the system implementing the method according to the present invention. The system (701) may be realized using dedicated components or custom made FPGA (Field-Programmable Gate Array) or ASIC (Application-Specific Integrated Circuit) circuits. The system comprises a data bus (702) communicatively coupled to other components of the system, including a memory (703). The memory (703) may be used for storage of any software and/or temporary processing results. Additionally, other components of the system are communicatively coupled to the system bus (702) so that they may be managed by a controller (705) configured to execute all the method steps according to the aforementioned Fig. 5 or method steps according to the aforementioned Fig. 6A and Fig. 6B.

The system further comprises an input interface (708) configured to obtain input data and to store an input sequence in an input sequence buffer (704). Similarly, after processing the input sequence by the controller (705), output data are stored in an output data buffer (706) and subsequently this set of data may be output to an output interface (707).

According to the present invention, the system also comprises a dictionaries database (709) comprising at least one part-of-speech dictionary. Optionally, this database may also store a set of rules applicable to selection of particular dictionaries during a process of analyzing and processing of input sequences.

As is clear from the aforementioned specification, the input sequence buffer (704), the output data buffer (706) and the dictionaries database (709) may be organized as sections of the main memory (703).

Fig.8 presents a sequence splitting example, where two overlapping output subsequences exist. This is possible embodiment of the present invention where additional output data properties are associated with output data.

As shown in Fig. 8, a 24-bit input sequence (801) has been split into two subsequences (802, 803), wherein the first subsequence (802) covers bits 0 to 15, while the second subsequence covers bits 8 to 23. Clearly the first and the second subsequences overlap.

Index 1 and Index 3 values formed by the respective subsequences, denote entries of the selected dictionaries. In this case, the method according to the present invention, applied a rule, where a representation selected from a first dictionary DICT_1 (the representation being indicated by the Index 1 value) must be followed by a representation selected from a particular second dictionary DICT_3 (the representation being indicated by the Index 3 value).

In order for the process to be reversible, output data properties (804) are associated with the input sequence representation data (in case the receiver has access to the same dictionaries, the output data properties may be the only output of the present method). The output data properties define that the output comprises a first subsequence S1 covering bits 0 to 15 and using dictionary DICT_1 as well as comprises a second subsequence S2 covering bits 8 to 23 and using dictionary DICT_3. In the present example, the output representation (805) of the input sequence is "black cat".

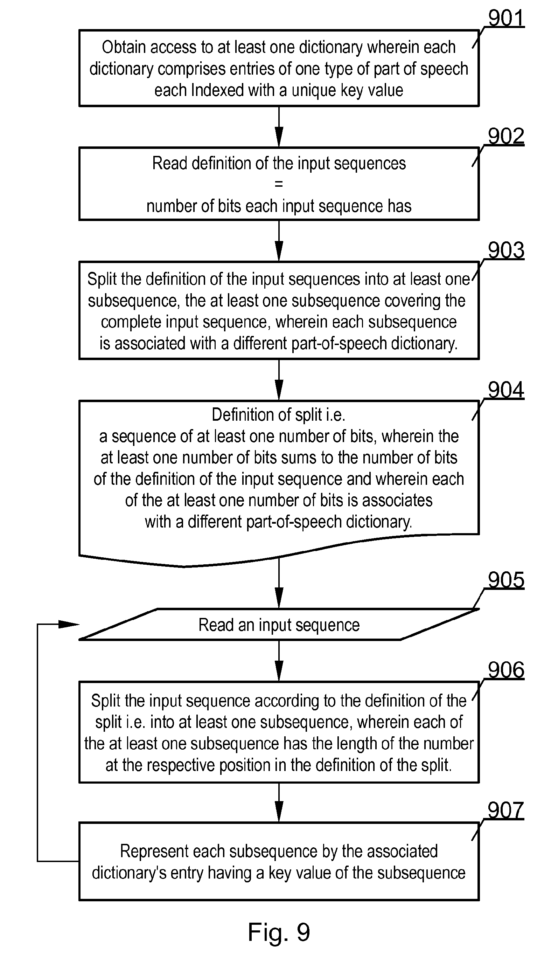

Fig. 9 presents another embodiment of the present invention. This embodiment of the present invention presents a modification of the embodiment according to Fig. 5 attempting at optimization of time of execution of the method according to the embodiment according to Fig. 5. The present embodiment changes the moment of splitting the input sequence of a known length.

Hence, the method begins at step (901) with obtaining access to at least one dictionary wherein each dictionary comprises entries of one type of part of speech each Indexed with a unique key value. Next, at step (902) a definition of the input sequence is determined. The input sequences are preferably sequences of bits of a known length. Therefore, the definition preferably comprises only one value that is the length of the input sequences.

Next, at step (903), the definition of the input sequences is split into at least one subsequence, the at least one subsequence covering the complete input sequence definition, wherein each subsequence is associated with a different part-of-speech dictionary. A subsequence is understood by the present embodiment as a number of bits i.e. length of the subsequence of every input sequence that will be read by the present embodiment at later steps.

Consequently, the result of the split is a definition of the split (904) i.e. a sequence of at least one number of bits, wherein the at least one number of bits sums to the number of bits of the definition of the input sequence. This definition of the split can be applied by the present invention to any input sequence of bits of length defined by the input sequence definition of step (902).

Hence, at step (905) an input sequence is read and at step (906) it is split according to the definition of the split (904) i.e. into at least one subsequence, wherein each of the at least one subsequence has the length of the number at the respective position in the definition of the split.

Next, at step (907), each subsequence is represented by the associated dictionary's entry having a key value of the subsequence.

Subsequently, the method preferably moves to step (905) to read another input sequence.

It is clear, to a one skilled in the art, that the operation (903) and (503) of splitting of the input sequence can be complex and/or time consuming. The present embodiment, of the present invention, allows to perform the splitting operation (903) only once and then apply (906) the split (904) to any input sequence of a defined length. This application step is fast hence allowing the present method of the present embodiment to execute much quicker than the original, not optimized method, according to the embodiment according to Fig. 5.

The present invention provides an unambiguous and reversible and easily implementable method to translate any sequence of symbols into a natural language clause that ensures easy readability. This in turn reduces greatly the potential for mistakes when identifying data by humans.

The present invention is most useful in conjunction with well known hashing algorithms to represent large data for human verification. Therefore, the invention provides a useful, concrete and tangible result.

The present invention may also be construed as a cipher translating numbers to words and vice-versa. Even if not at all strong as a standalone cipher the present invention may be used to strengthen other methods or to prepare data for other cipher methods requiring e.g. human readable glyphs on input.

Applications of the present invention involve a particular system for data processing, as described above. Thus, the machine or transformation test is fulfilled and the idea is not abstract.

It can be easily recognized, by one skilled in the art, that the aforementioned method for representing sequences of bits may be performed and/or controlled by one or more computer programs. Such computer programs are typically executed by utilizing the computing resources in a computing device. Applications are stored on a non-transitory medium. An example of a non-transitory medium is a nonvolatile memory, for example a flash memory while an example of a volatile memory is RAM. The computer instructions are executed by a processor. These memories are exemplary recording media for storing computer programs comprising computer-executable instructions performing all the steps of the computer-implemented method according the technical concept presented herein.

While the invention presented herein has been depicted, described, and has been defined with reference to particular preferred embodiments, such references and examples of implementation in the foregoing specification do not imply any limitation on the invention. It will, however, be evident that various modifications and changes may be made thereto without departing from the broader scope of the technical concept. The presented preferred embodiments are exemplary only, and are not exhaustive of the scope of the technical concept presented herein.

Accordingly, the scope of protection is not limited to the preferred embodiments described in the specification, but is only limited by the claims that follow.

## Claims

1. A computer-implemented method for representing sequences of bits, the method being **characterized in that** it comprises the steps of:
• obtaining access to at least one dictionary, wherein each dictionary comprises entries of one type of part of speech each indexed with a unique key value (501);
• reading an input sequence of bits, the sequence being of a defined length (502); and
• splitting the input sequence into at least one subsequence, the at least one subsequence covering the complete input sequence, wherein each subsequence is associated with a part-of-speech dictionary and is represented by the associated dictionary's entry having a key value of the subsequence (503).

2. The method according to claim 1 **characterized in that** each subsequence is associated with a different part-of-speech dictionary and is represented by the associated dictionary's entry having a key value of the subsequence (503).

3. The method according to claim 1 **characterized in that** the subsequences overlap.

4. The method according to claim 1 **characterized in that** a sequence of dictionaries applied to a respective sequence of subsequences is predefined using rules.

5. The method according to claim 1 **characterized in that** the step of splitting the input sequence into at least one subsequence, comprises the following steps:
• obtaining access (603) to a first dictionary of all dictionaries obtained at step (501);
• determining (604), whether the input sequence definition has no more distinct possible sequences than the count of first parts of speech in the first parts-of-speech dictionary;
• in case it does (605) each sequence according to the input sequence definition is represented by a first part of speech indicated by the unique key having value of the input sequence.

6. The method according to claim 5 **characterized in that** if the determination step (604) returns false, the method proceeds to:
• splitting (607) the input sequence into a pair of subsequences, the first of the pair having distinct items count no higher than the count of first parts of speech in the first parts-of-speech dictionary;
• representing (608) the first sequence of the pair by a first part of speech indicated by the unique key having value of the first subsequence of the pair;
• in case when more dictionaries are available (609), obtaining access (611) to a second part-of-speech dictionary;
• determining (612) whether the second subsequence of the pair has no more distinct possible sequences than the count of second parts of speech in the second parts-of-speech dictionary;
• In case it does, representing (614) the second sequence of the pair by a second part of speech indicated by the unique key having value of the second subsequence of the pair.

7. The method according to claim 6 **characterized in that** if the determination step (612) returns false, the method proceeds to:
• removing (613) the first parts of speech dictionary from the set of available dictionaries and setting the second subsequence of the pair as the input sequence;
• returning to the splitting step (607).

8. The method according to claim 6 **characterized in that** if the determination step (612) returns false, the method proceeds to:
• removing (613) the first parts of speech dictionary from a new set of available dictionaries and setting the second subsequence of the pair as the input sequence;
• returning to the splitting step (607).

9. The method according to claim 6 **characterized in that** the second part-of-speech dictionary is selected so that the resulting clause is a grammatically correct clause.

10. The method according to claim 1 **characterized in that** it further comprises the steps of:
• determining (902) a definition of the input sequence;
• splitting (903), the definition of the input sequences into at least one subsequence, the at least one subsequence covering the complete input sequence definition, wherein each subsequence is associated with a different part-of-speech dictionary;
• obtaining a definition of the split (904) as a result of the splitting step (903);
• splitting (905) at least one input sequence according to the definition of the split (904).

11. A computer program comprising program code means for performing all the steps of the computer-implemented method according to claim 1 when said program is run on a computer.

12. A computer readable medium storing computer-executable instructions performing all the steps of the computer-implemented method according to claim 1 when executed on a computer.

13. A system for representing sequences of bits, the system comprising:
• a data bus (702) communicatively coupled to other components of the system;
• a memory (703);
• a controller (705);
the system being **characterized in that** it further comprises:
• an input interface (708) configured to obtain input data and to store an input sequence in an input sequence buffer (704);
• an output data buffer (706) configured to store output data passed to an output interface (707);
• a dictionaries database (709) comprising at least one part-of-speech dictionary;
• wherein the controller (705) configured to execute all the method steps according to claim 1.

14. The system for representing sequences of bits according to claim 13 **characterized in that** it further comprises:
• a dictionaries database (709) further including rules applicable to selection of particular dictionaries during a process of analyzing and processing of input sequences.
